# EUROPEAN PATENT APPLICATION

(11) **EP 0 715 403 A1**
(43) Date of publication of application: **05.06.1996**
(21) Application number: 95308604.8
(22) Date of filing: 29.11.1995
(51) Int. Cl.: H03D 7/16

(54) **A satellite tuner stage**

(30) Priority: 29.11.1994 GB 9424056
(71) Applicant: SGS-Thomson Microelectronics Limited, Marlow, Buckinghamshire SL7 1YL (GB)
(72) Inventor: James, John C., Welwyn Garden City, Herts (GB)
(74) Representative: Driver, Virginia Rozanne

(57) **Abstract**

A tuner stage of a satellite receiver system, receiving a signal from a low noise block for selecting a required channel carrier frequency, that comprises: an oscillator (20) for providing output signals at a selected frequency that have a 90° phase difference; first and second mixers (18a,18b) for mixing the signal from the low noise block with the signals from the oscillator (20); a means (22) for introducing a further 90° phase shift between the output signals of the mixer (18a,18b) at a required frequency that is equal to the difference between the selected frequency and the required channel carrier frequency; a first switchable summer (24) for summing the signals from said means; and a filter (26), whose centre frequency equals the required frequency, for filtering the summed signals.

## Description

The present invention relates to a method and apparatus for selecting a required channel carrier frequency from satellite relayed signals such as television signals i.e. combined audio-video signals. More particularly, this invention relates to a tuning stage of a satellite receiver system that is capable of selecting or 'tuning into' a required channel, whilst at the same time providing substantial rejection of image frequencies.

In current satellite receiver systems, the 'tuning' of a required channel carrier frequency is carried out by a tuning stage that includes a tracking filter. The tracking filter is an adjustable bandpass filter that can be 'tuned' to allow only the required first intermediate frequency (IF) signal to pass, this first IF signal corresponding to the required channel carrier frequency. Furthermore, the tracking filter enables the substantial rejection or attenuation of the image frequency that is associated with the required channel carrier frequency.

Tracking filters are notorious in their requirement for precisely matched and accurately tuneable varactor diodes. Thus, they require expensive solid state components, as well as 'bulky' wound components. Additionally, tracking filters incur additional costs since they have to be manually 'fine tuned' during their assembly.

The UK Patent Application GB2223900 Po Ping et Al is a pertinent example of a satellite tuner incorporating a tracking filter as is US Patent 5,060,297 Ma et Al. The latter document does however claim to reduce the need for matched varactor diodes and accurate filter tuning. Nevertheless, a satellite receiver that uses a tracking filter to surpress image frequencies will always have a significant cost that is related to the quality and number of components required for implementing and controlling the tracking filter. Also, the tracking filter requires and indeed occupies a substantial surface area since special connection, layout and shielding techniques have to be implemented so that noise and parasitic effects are minimised. Furthermore, more assembly is required and this leads to reduced reliability.

Accordingly, an object of the present invention is to provide a satellite receiver that enables substantial rejection, or attenuation, of image frequencies without the requirement of a tracking filter.

Another object of the present invention to provide a satellite receiver tuning stage that can be substantially integrated on a monolithic semiconductor substrate.

A further object of the present invention is to provide a satellite receiver tuning stage that provides good noise rejection.

The objects of the present invention are attained by a tuner stage, receiving an input signal, that comprises: an oscillator; first and second mixers for mixing the input signal with signals from the oscillator; a means for introducing a phase shift between the signals from the mixers; a summer for summing the phase shifted signals; and a filter for filtering the summed signals. More specifically, the invention provides a tuner stage of a satellite receiver system, receiving a first signal from a low noise block, for selecting a required channel carrier frequency, that comprises: an oscillator for providing second and third signals at a selected frequency, the second and third signals having a phase difference of substantially 90°; a first mixer for mixing the first signal with the second signal and providing a fourth signal; a second mixer for mixing the first signal with the third signal and providing a fifth signal; a means, that produces sixth and seventh signals, for introducing a further phase shift of substantially 90° between the fourth and fifth signals at a required frequency that is equal to the difference between the selected frequency and the required channel carrier frequency; a first summer for summing the sixth and seventh signals; and a first filter, whose centre frequency equals the required frequency, for filtering the summed signals.

According to an embodiment of the invention, it further comprises a second summer for summing the sixth signal and the inverse signal of the seventh signal and a means for controlling the first and second summers such that only one of the summers provides summed signals.

According to another embodiment of the invention, it further comprises: a first amplifier for amplifying the first signals; a second amplifier for amplifying the fourth signal; and a third amplifier for amplifying the fifth signal.

According to another embodiment of the invention, it further comprises a first low pass filter placed between the first mixer and the second amplifier and a second low pass filter placed between the second mixer and the third amplifier.

According to another embodiment of the invention, the means for introducing a further phase shift of substantially 90° comprises a means for introducing a phase-lag of substantially 45° into one of the fifth or sixth signals and a means for introducing a phase-lead of substantially 45° into the other of said fifth or sixth signals.

According to other embodiments of the invention, all of the signals are differential signals or all of the signals, with the exception of the output signal i.e. the summed signals, are differential signals.

According to another embodiment of the invention, the first amplifier is a transconductance amplifier and the second and third amplifiers are transimpedance amplifiers.

According to another embodiments of the invention, the oscillator provides limited amplitude output signals and/or output signals that have a duty cycle of one i.e. equal mark-to-space ratios.

According to another embodiment of the invention, the means for introducing a phase-lag of substantially 45° and the means for introducing a phase-lead of substantially 45° are filters.

According to another embodiment of the invention, the means for introducing a phase-lag of substantially 45° and the means for introducing a phase-lead of substantially 45° are Hilbert filters.

According to another embodiment of the invention, the first filter is a precision bandpass filter.

According to another embodiment of the invention, the first filter is a surface acoustic wave (SAW) filter.

According to another embodiment of the invention, it is implemented on a single semiconductor substrate.

According to another embodiment of the invention, it is implemented on a single semiconductor substrate, with the exception of the oscillator and the first filter.

According to another embodiment of the invention, it is incorporated within a television set and/or a video recorder.

The invention also provides a method for selecting a required channel carrier frequency from a block of input signals of a satellite receiver system, that comprises the following steps: applying the block of input signals to a first and a second mixer; applying a signal, that has a selected frequency and that is in-phase with respect to the required channel carrier frequency within the block signals, to the first mixer; applying a signal, that has said selected frequency and that has a phase difference of substantially 45° with respect to the required channel carrier frequency within the block signals, to the second mixer; introducing a further phase difference of substantially 90° between the output signals of the mixers, at a required frequency that is equal to the difference between the selected frequency and the required channel carrier frequency, to provide first and second signals; summing, with a first summer, the first and second signals; and filtering the summed signals with a filter whose centre frequency equals the required frequency.

Another embodiment of the method of the invention, further comprises the following steps: summing, with a second summer, the first signal and the inverse of the second signal; and controlling the first and second summers such that only one summer provides summed signals.

According to another embodiment of the method of the invention, the step of introducing a further phase difference of substantially 90° between the output signals of the mixers comprises the following steps: introducing a phase-lag of substantially 45° into one of the output signals of one of the mixers; and introducing a phase-lead of substantially 45° into the other of the output signals of the other of the mixers.

According to another embodiment of the method of the invention, it further comprises the following steps: amplifying the block signals prior to their application to the first and second mixers; filtering out high frequency signals of the output signals of the mixers; amplifying the low frequency signals prior to introducing the further phase difference of substantially 90°.

In a further aspect the invention provides a tuner stage for selecting a channel at a required carrier frequency from an incoming signal comprising a plurality of different carrier frequencies, the tuner stage comprising, a terminal for receiving said incoming signal, first and second mixer circuits connected to said terminal for mixing said incoming signal with respective mixer signals which are at the same selected frequency and which have a phase shift of substantially 90° between them, for generating respective mixer output signals, a phase shift circuit connected to receive said mixer output signals and arranged to introduce a phase shift of substantially 90° between them at an intermediate frequency that is equal to the difference between said selected frequency and said required carrier frequency, to generate first and second signals, a summing circuit for summing said first and second signals to generate a combined signal and a filter with a centre frequency matching said intermediate frequency, for filtering said combined signal to select said channel.

In a still further aspect the invention provides a method for selecting a channel at a required frequency from an incoming signal comprising a plurality of different carrier frequencies, comprising the steps of mixing said incoming signal with first and second mixer signals which are at the same selected frequency and have a phase shift of substantially 90° between them, to produce first and second mixer output signals, introducing a phase shift of substantially 90° between the first and second mixer output signals at an intermediate frequency that is equal to the difference between said selected frequency and said required carrier frequency to generate first and second signals, summing said first and second signals to create a combined signal and filtering said combined signal by means of a filter with a centre frequency matching said intermediate frequency to select said channel.

These and other objects, as well as other advantages and features, of the present invention will become apparent in light of the following detailed description and accompanying drawings in which:
Figures 1a and 1b respectively illustrate a basic functional block diagram of a satellite receiver tuning stage according to the invention and the phase relationship between its associated signals;
Figures 2a and 2b respectively illustrate a more detailed block diagram and a detailed circuit diagram of the first amplifier of Figure 1a;
Figure 3a illustrates a more detailed block diagram of the mixer of Figure 1a;
Figure 3b illustrates a detailed circuit diagram of one of the double balanced mixers of Figure 3a;
Figure 4 illustrates the basic block diagram of the oscillator of Figure 1a;
Figure 5 illustrates a detailed circuit diagram of the second and third amplifiers of Figure 1a;
Figures 6a and 6b illustrate detailed block diagrams of the phase splitter of Figure 1a;
Figures 7a and 7b respectively illustrate the a.c. analysis of the two all pass filters of Figure 6b and a circuit diagram of the all pass filters of Figure 6b; and
Figures 8a and 8b respectively illustrate detailed block and circuit diagrams of the summer of Figure 1a.

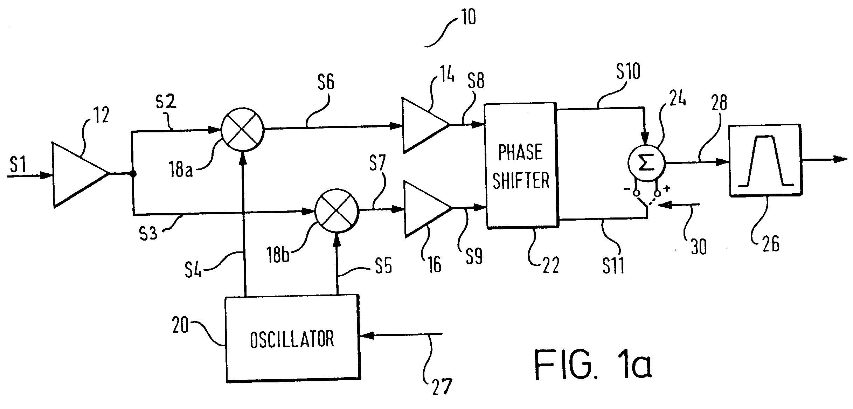

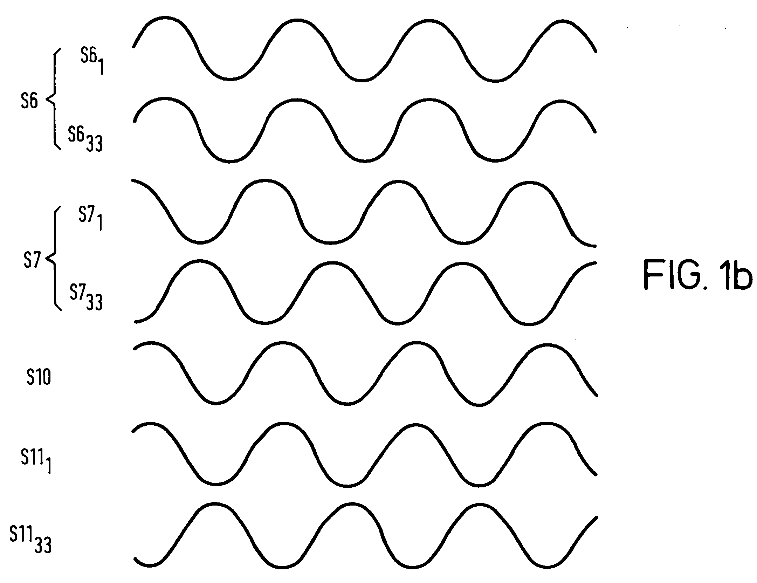

Figures 1a and 1b respectively illustrate a basic functional block diagram of a satellite receiver tuning stage according to the invention and the phase relationship between its associated signals.

Referring to Figure 1a, the tuning stage 10 includes: first, second and third amplifiers 12, 14 and 16; first and second mixers 18a, 18b; an oscillator 20; a phase shifter 22; a summer 24; and a filter 26.

The first amplifier 12 receives a block of signals S1 from a low noise block (LNB) down converter (not illustrated). This block of signals S1 typically has a frequency range from approximately 950MHz to 2150MHz. Amplifier 12 amplifies the block of signals S1 to produce two sets of block signals (S2 and S3) which are respectively input to the mixers 18a and 18b. The advantage of producing two sets of block signals is that when the system is integrated on a monolithic semiconductor substrate, the signal paths can be extremely well matched.

Since, for European satellite receiver systems, the desired second IF frequency at the output 28 of the tuner stage 10 is typically 480 MHz; with a typical bandwidth of +/-15MHz, the frequency range of the oscillator 20 is from approximately 1430MHz to 2630MHz. Therefore, the oscillator 20, which is a quadrature oscillator, can be adjusted via an input control terminal 27, so that it can 'lock onto' the frequency and phase of a desired channel carrier centre frequencies of the block signal S1 and produce output signals S4, S5 at a particular frequency f_{LO}. One of the output signals of the oscillator is in-phase with the desired channel carrier centre frequency, whilst there exists a 90° phase difference between the other oscillator output signal and the desired channel carrier centre frequency. The frequency f_{LO} of the oscillator output signals S4, S5 can correspond to any one of the channel carrier centre frequencies within the composite block signal S1.

Mixer 18a mixes the signals S1 and S4 to produce an output signal S6, whilst mixer 18b mixes the signals S1 and S5 to produce an output signal S7. The respective signals S6 and S7 contain many 'down converted', i.e. frequency shifted, signals. It is essential that the signals S4 and S5 both have 1:1 mark-to-space ratios so as to avoid distortion and noise effects when mixing the signals.

Since the required second IF of 480MHz represents the preselected constant difference frequency between the first IF channel carrier frequency and the output frequency f_{LO} of the oscillator 20; since 480MHz is a multiple of the 30MHz bandwidth between the channel frequencies, the mixers 18a, 18b will respectively produce signals S6, S7 that each contain two frequency signals centred around the required second IF carrier frequency, i.e. 480MHz, that respectively correspond to the required channel carrier frequency and its undesired image channel carrier frequency.

Table 1 respectively illustrates the Channel No:, Channel Centre Frequency, High Frequency Signal (HFS), and Low Frequency Signal (LFS) for an oscillator frequency f_{LO} of 1430MHz. It should be noted that the HFS=Channel Centre Freqency + f_{LO} and that LFS=Channel Centre Frequency - f_{LO}.

**Table 1.**

| Channel No: | Channel Centre Frequency | High Frequency Signal (HFS) | Low Frequency Signal (LFS) |
|---|---|---|---|
| 1 | 950 | 2380 | 480 |
| 2 | 980 | 2410 | 450 |
| 3 | 1010 | 2440 | 420 |
| 4 | 1040 | 2470 | 390 |
| : | : | : | : |
| : | : | : | : |
| 30 | 1820 | 3250 | -390 |
| 31 | 1850 | 3280 | -420 |
| 32 | 1880 | 3310 | -450 |
| 33 | 1910 | 3340 | -480 |
| 34 | 1940 | 3370 | -510 |

From Table 1, it can be seen that for f_{LO}=1430MHz, both the output signals S6, S7 from the respective mixers 18a, 18b will each contain 480MHz signals, amongst others, that correspond to channels 1 and 33, channel 33 being the undesired image channel. Similarly when f_{LO}=1480MHz, both the output signals S6, S7 from the respective mixers 18a, 18b will each contain 480MHz signals that correspond to channels 2 and 34, channel 34 being the undesired image channel, and so on.

Since the two 480MHz components of both signals S6 and S7 are derived from lower and upper sidebands, i.e. respectively 950MHZ (Channel 1) and 1910MHz (Channel 33), that are centred about f_{LO}, the mixer that mixes the block signal with the 'out of phase' oscillator signal introduces a -90° phase shift into the 480MHz component that is derived from the lower sideband, i.e. 950MHz, and a +90° phase shift into the 480MHz component that is derived from the upper sideband, i.e. 1910MHz, thus the two 480MHz components are distinguishable. The mixer that mixes the block signal S1 with the in-phase oscillator signal introduces no phase shift into the 480MHz components that are derived from the lower and upper sidebands, i.e. respectively 950MHz and 1910MHz, thus the two 480MHz components are indistinguishable.

Referring to Figure 1b, which is an exemplification of the phase relationships between the two 480MHz components of signals S6 and S7, it can be seen that the two 480MHz signals of channels 1 and 33, respectively S6₁, S6₃₃ , within signal S6 are in phase and that S71 lags S6 by 90° and S7₃₃ leads S6 by 90°; S7₁ and S7₃₃ being the respective 480MHz signals of channels 1 and 33 within signal S7.

Referring back to Figure 1a, signals S6 and S7 are passed through a low pass filter (not illustrated) so that only their low frequency components remain, the high frequency components being substantially rejected or attenuated. The respective low frequency components of signals S6, S7 are amplified by the respective second and third amplifiers 14, 16, which are transimpedance amplifiers whose output signals S8, S9 have sufficient power to drive the phase shifter 22. It should be noted that the amplifiers 14 and 16 do not alter the phase relationship of, or between, the input signals S6 and S7. Therefore, the respective signals S8 and S9 have the same phase relationship as the respective signals S6 and S7 - see Figure 1b.

The phase shifter 22 is in fact a filter, and more particularly an all pass filter; an all pass filter is also known as a Hilbert filter. The general purpose of an all pass is to alter only the phase relationship between inputted signals, the amplitudes between the input and output signals of the all pass filter being substantially unaltered. Thus, the signals S10 and S11 are substantially the same as the respective signals S8 and S9 except that the phase relationship between signals S10 and S11 is different to the phase relationship between signals S8 and S9.

Referring back to Figure 1b, it can be seen that the phase relationship between the output signals S10 and S11 of the all pass filter 22 have been manipulated by the all pass filter such that signal S11₁ is in-phase with signal S10 (S10₁, S10₃₃) and signal S11₃₃ is 180° out of phase with signals S10 and S11₁.

Referring back to Figure la, the signals S10 and S11 are inputted to a switchable summing device 24 that adds together signals S10 and S11₃₃ so that the 480MHz signal associated with channel 33 is substantially cancelled, i.e. the antiphase signals S10₃₃ and S11₃₃ substantially cancel each other, which leaves the sum of the signals S10₁ and S11₁ at the output 28 of the tuner stage 10, this signal S10₁+S11₁ corresponding to the required channel carrier frequency.

Therefore, this technique of creating signals that have in-phase signals (S10₁, S10₃₃, S11₁) and an antiphase signal (S11₃₃) allows the summer 24 to be controlled so as to substantially cancel the undesired image frequency, and this being achieved without a tracking filter.

The output terminal 28 of the tuning stage 10 is connected to a filter 26, for example a surface acoustic wave (SAW) filter, that has a very precise bandpass characteristic which allows only the 480MHz carrier signal and its modulated information signal to pass. The output of the filter 26 can then be connected to other necessary circuitry for manipulating and conditioning the signal so that images and sounds are produced for an appropriate display and/or recording apparatus.

In order for this arrangement to work effectively, it is necessary that the various 'like' components are extremely well matched. Furthermore, it is desirable that the oscillator 20 and the phase shifter 22 each a phase shift that is as close as possible to 90°.

An alternative arrangement (not illustrated) at the input of the tuning stage 10 includes an additional amplifier whose output(s) is connected to the output(s) of amplifier 12 and whose input is separate from that of amplifier 12. One such application of this arrangement: wherein two, or more, amplifiers 12 are required; is when there are block signals from two different LNBs: the respective amplifiers or block signals having a mutually exclusive operation or presence.

An alternative arrangement (not illustrated) at the output of the tuning stage 10 includes an additional summer whose inputs are connected to the inputs of summer 24 and whose output is separate from that of summer 24. One such application of this arrangement: wherein two, or more, summers are required; is when the signals on the respective outputs of the respective summers need to be filtered by different filters that have different bandpass frequencies. For example one filter can have a bandpass frequency range of +/-15MHz centred around 480MHz and the other filter can have a bandpass frequency range of +/-13.5MHz centred around 480MHz.

The principle of operation of Figure 1a is not limited to a European satellite system. The tuner stage 10 can have its component blocks adapted so that it provides image frequency rejection for satellite receiver systems that require an output carrier frequency other than 480MHz. For example, the tuner stage can be adapted such that it filters the image frequency of a 612MHz signal - refer to US Patent 5,060,297 Ma et Al.

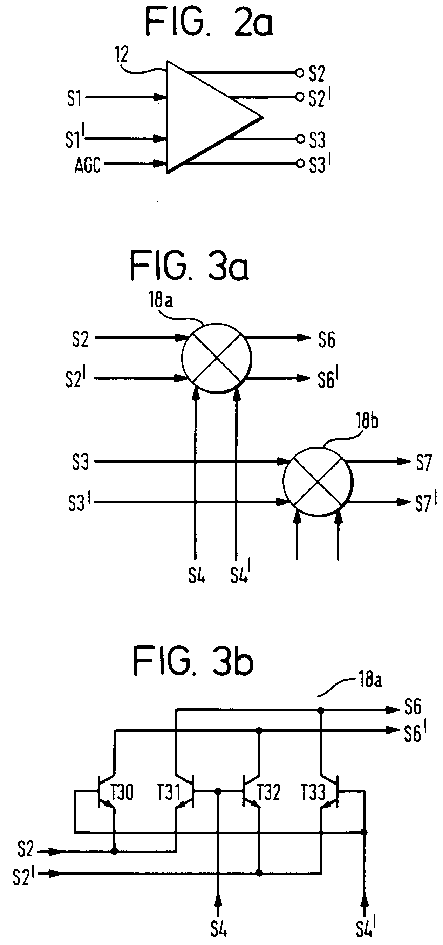

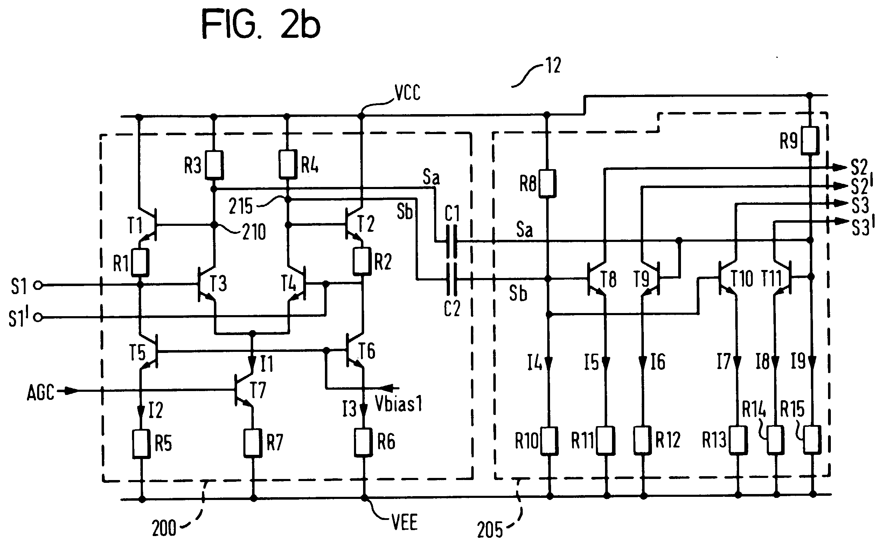

Figures 2a and 2b respectively illustrate a more detailed block diagram and a detailed circuit diagram of the first amplifier of Figure 1a.

Referring to Figure 2a, this diagram illustrates a block diagram of the amplifier 12 of Figure la in which the input and output terminals of the amplifier are illustrated as being differential input and output terminals that respectively receive a differential block signal S1, S1' and produces two differential blocks of signals S2, S2' and S3, S3'.

Figure 2b illustrates a detailed circuit diagram of that of Figure 2a.

Referring to Figure 2b, this illustrates a low noise transconductance amplifier that has automatic gain control AGC. The amplifier 12 can be separated into two functional circuits. The first of these functional circuits being a differential amplifier 200 and the second being a voltage-to-current converter 205, i.e. a transconductance converter. The important criteria for this low noise amplifier 12 is that the differential amplifier 200 should be terminated into 75ohms: 75ohms being the characteristic impedance of the system; and it should have its bias current, i.e. 'tail' current I1, optimised so as to minimise unwanted noise for its given characteristic impedance.

The differential amplifier 200 comprises seven npn-type transistors T1-T7 and seven resistors R1-R7. Resistors R3 and R4 are respectively connected between a positive voltage source VCC and the respective collectors of transistors T3 and T4, which are designated as nodes 210 and 215. The emitters of transistors T3 and T4 are both connected to the collector of transistor T7 whose emitter is connected to a negative voltage source VEE via resistor R7. The AGC control signal acts upon the base of transistor T7 so as to control the 'tail' current I1 flowing through transistor T7 and resistor R7. The collector of transistor T1 is connected to the source VCC whilst its emitter is connected to the base of transistor T3 via resistor R1 and its base is connected to the collector 210 of transistor T3. The collector of transistor T2 is connected to the source VCC whilst its emitter is connected to the base of transistor T4 via resistor R2 and its base is connected to the collector 215 of transistor T4. The base terminals of transistors T3 and T4 are respectively connected to the collectors of transistors T5 and T6 whose respective emitters are connected to the source VEE via resistors R5 and R6. The base terminals of transistors T5 and T6 are connected together and biased by the voltage Vbiasl. Components T1, R1, T5 and R5 are selected so as to d.c. bias the base of transistor T3 and components T2, R2, T6 and R6 are selected so as to d.c. bias the base terminal of transistor T4. The base terminals of transistors T3 and T4 respectively receive the differential block signal S1 and S1'. The differential block output signal Sa, Sb of amplifier 200, which is respectively derived from nodes 210 and 215, is respectively a.c. coupled via capacitors C1 and C2 to the voltage-to-current converter 205. If the signals Sa and Sb are not a.c. coupled from the differential amplifier 200 to the transimpedance stage 205 unnecessary noise will be introduced onto the signals Sa, Sb due to the resistance's associated with level shifting emitter followers stages. Because the noise specification for a satellite receiver system is extremely demanding, it is essential that the output signals of the differential amplifier 200 are a.c. coupled to the transconductance stage 205.

The voltage-to-current converter 205 comprises four npn-type transistors T8-T11 and eight resistors R8-R15. Transistors T8-T11 have their respective emitters connected to the source VEE via the respective resistors R11-R14. Resistors R8 and R10 form a potential divider so as to d.c. bias the base terminals of transistors T8 and T10, i.e. resistor R8 is connected between the source VCC and the base terminals of transistors T8 and T10 and resistor R10 is connected between the source VEE and the base terminals of transistors T8 and T10 . Similarly, resistors R9 and R15 form a potential divider so as to d.c. bias the base terminals of transistors T9 and T11, resistor R9 being connected between the source VCC and the base terminals of transistors T9 and T11 and resistor R15 being connected between the source VEE and the base of transistors T9 and T11. The base terminals of transistors T9 and T11 receive the a.c. coupled signal Sa from capacitor C1 and the base terminals of transistors T8 and T10 receive the a.c. coupled signal Sb from capacitor C2. Therefore, transistors T8 and T9 respectively provide the differential 'tail' current signals S2 and S2' and transistors T10 and T11 respectively provide the differential 'tail' current signals S3 and S3'.

Typical component values used within the amplifier 12 are: R1=R2=300ohms; R3=R4=25ohms; R5=R6=150ohms; R7=28ohms; R8=R9=6000ohms; R10=R15=2500ohms; R11=R12=R13=R14=50ohms; C1=C2=5pFarads; the amplifier 12 having an overall gain of approximately 12dBs.

Figure 3a illustrates a more detailed block diagram of the mixer of Figure 1a.

Referring to Figure 3a, mixers 18a and 18b are double balanced mixers. Mixer 18a receives and mixes the differential input signals S2, S2' and S4, S4' and produces the differential output signal S6, S6' and mixer 18b receives and mixes the differential input signals S3, S3' and S5, S5' and produces the differential output signal S7, S7'. It must be remembered that the differential signals S4, S4' and S5, S5' have a 90° phase difference, therefore the differential signals S6, S6' and S7, S7' will have a 90° phase difference. It is customary to refer to signals that have a 90° phase difference as the I and Q signals; a signal that has a 90° phase lag with respect to another signal is designated the Q signal, the other being the I signal.

Figure 3b illustrates a detailed circuit diagram of one of the double balanced mixers of Figure 3a.

Referring to Figure 3b, this illustrates the mixer 18a, which is identical to mixer 18b, and it comprises four npn-type transistors T30-T33 that are arranged as a pair of cross-coupled long tail pairs. To be more specific, the emitters of transistors T30 and T31 are connected together and receive the signal S2, the emitters of transistors T32 and T33 are connected together and receive the signal S2', the base terminals of transistors T31 and T32 are connected together and receive the signal S4, the base terminals of transistors T30 and T33 are connected together and receive the signal S4', the collectors of transistors T30 and T32 are connected together and provide the signal S6', and the collectors of transistors T31 and T33 are connected together and provide the signal S6. Because the mixers are not complex, it will be possible to make them such that they are extremely well matched.

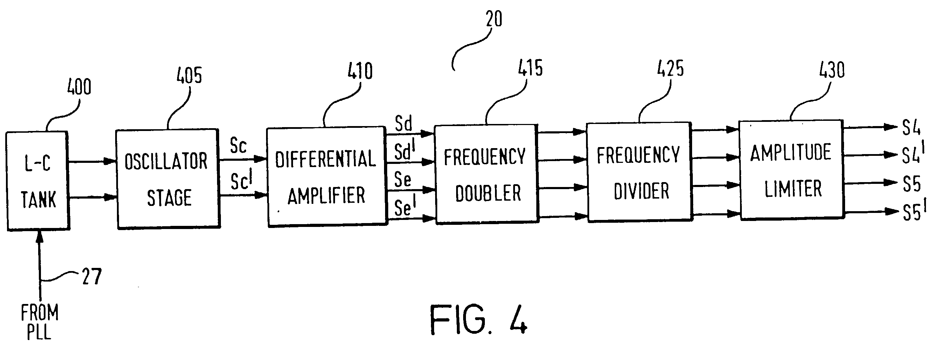

Figure 4 illustrates the basic block diagram of the quadrature oscillator of Figure 1a. The quadrature oscillator 20 comprises: an L-C tank circuit 400; an oscillator stage 405; a differential amplifier 410; a frequency doubler 415; a frequency divider 425; and an amplitude limiter 430.

The L-C tank circuit 400, which is controlled by a phase-locked loop, is used to excite the oscillator stage 405 which provides a differential output signal Sc, Sc'. The differential signals Sc, Sc' are fed into the differential amplifier 410 which provides amplified in phase differential output signals Sd, Sd' and Se, Se' at a required frequency. The signals Sd, Sd' and Se, Se' are fed into a frequency doubler 415 which again adds gain to the signals. The output signals of the frequency doubler 415 pass into a frequency divider 425, which divides the frequency of its incoming signals and produces a 90° phase difference between its differential output signals. The differential output signals are input to an amplitude limiter 430. The output signals from the amplitude limiter are the 90° phase shifted differential signals S4, S4' and S5,S5'.

There are of course many known ways in which to implement a quadrature oscillator . However, the essential feature concerning the output signals S4, S4' and S5, S5' is that they both have a 1:1 mark-to-space ratio and that there amplitudes are limited to approximately 0.5V peak-to-peak. The oscillator 20 can either be a digital oscillator or an analogue oscillator, equally, it can have digital and analogue elements.

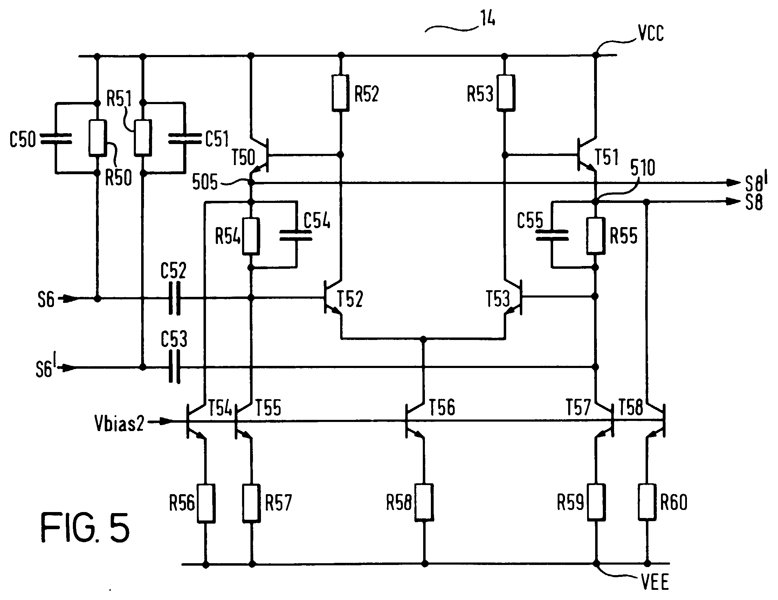

Figure 5 illustrates a detailed circuit diagram of the second and third amplifiers of Figure la.

Referring to Figure 5, this illustrates a suitable realisation of the transimpedance low power amplifier 14 of Figure la. It is identical to amplifier 16 and has a low input impedance. Amplifier 14 essentially comprises a differential low power amplifier that is composed of nine npn-type transistors T50-T58, eleven resistors R50-R60 and six capacitors C50-C55.

Resistors R50 and R51 are respectively connected in parallel with capacitors C50 and C51, one side of resistor R50 is connected to the source VCC, the other side of this resistor being connected to one side of the capacitor C52 and one side of resistor R51 is connected to the source VCC, the other side of this resistor being connected to one side of the capacitor C53. The connection between R50 and C52 receives the signal S6, whilst the connection between R51 and C53 receives the signal S6'. Resistors R52 and R53 are respectively connected between the source VCC and the respective collectors of transistors T52 and T53. The emitters of transistors T52 and T53 are both connected to the collector of transistor T56 whose emitter is connected to the source VEE via resistor R58.

The collector of transistor T50 is connected to the source VCC whilst its base is connected to the collector of transistor T52 and its emitter, which is designated as node 505, is connected to the collector of transistor T54 and one side of the resistor R54: resistor R54 and capacitor C54 being connected in parallel. The other side of resistor R54 is connected to the base of transistor T52, the collector of transistor T55 and the side of capacitor C52 that is not connected to resistor R50. The respective emitters of transistors T54 and T55 are connected to the source VEE via the respective resistance's R56 and R57.

The collector of transistor T51 is connected to the source VCC whilst its base is connected to the collector of transistor T53 and its emitter, which is designated as node 510, is connected to the collector of transistor T58 and one side of the resistor R55: resistor R55 and capacitor C55 being connected in parallel. The other side of resistor R55 is connected to the base of transistor T53, the collector of transistor T57 and the side of capacitor C53 that is not connected to resistor R51. The respective emitters of transistors T57 and T58 are connected to the source VEE via the respective resistance's R59 and R60. The base terminals of transistors T54-T58 are all connected together and biased by the voltage Vbias2.

Resistors R50 and R51 act so as to bias the mixer 18a (see Figures 3a. and 3b.) and the capacitors C50 and C51 act as high pass filters, i.e. they let the high frequency component of the signal S6, S6' pass through to the supply and reject the two low frequency components (480MHz) which are presented to the decoupling capacitors C52 and C53.

Since the transimpedance amplifier 14 is specifically designed so that it has a lower input impedance than that of the RC combinations R50, C50 and R51, C51, the current signals S6, S6' flow into the amplifier 14 where they are amplified and the noise 'in band', i.e. the noise associated with the signal, is kept to a minimum since only a small portion of the signal passes through the resistors R50 and R51 which act as noise sources. This technique is used to optimise the noise specification of the system. The respective amplified differential voltage output signals S8, S8' are present on the respective nodes 505 and 510.

Components T50, T54, T55, R54, R56, R57 and C54 are selected so as to d.c. bias the output signal S8' and components T51, T57, T58, R55, R59, R60 and C55 are selected so as to d.c. bias the output signal S8. Resistors R52, R53 and R58 are selected so as to set the gain of the long tail pair T52, T53.

Typical resistive and capacitive values used within the power amplifiers are: R50=R51=1800hms; R52=R53=600ohms; R54=R55=720ohms; R56=R60=80ohms; R57=R59=350ohms; R58=100ohms; C50=C51=3.6pFarads; C52=C53=12pFarads; C54=C55=0.05pFarads.

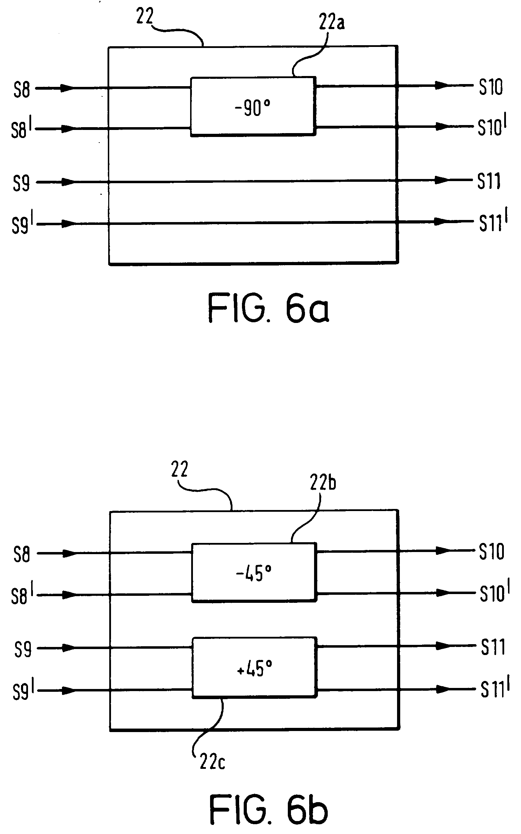

Figures 6a and 6b illustrate detailed block diagrams of the phase shifter of Figure la.

Referring to Figure 6a, this illustrates an all pass filter 22a that introduces a -90° phase shift to only the differential signals S8, S8': assuming the signals S8, S8' represent the I signals and signals S9, S9' represent the Q signals; at a particular frequency. Alternatively, Figure 6a could have illustrated an all pass filter that introduces a +90° phase shift to only the differential signals S9, S9'.

Referring to Figure 6b, this illustrates two all pass filters 22b and 22c that each introduce a 45° phase shift to the differential signals S8, S8' and S9, S9' at a particular frequency. Again, assuming the signals S8, S8' represent the I signals and signals S9, S9' represent the Q signals, filter 22b must introduce a -45° phase shift into signals S8, S8' and filter 22c must introduce a +45° phase shift into signals S9, S9'. It is conceivable that filters 22b and 22c can be designed and operated such that the output signals S8, S8' and S9, S9' have a 90° phase difference introduced between them, yet the respective phase shifts introduced by filters 22b and 22c to the I and Q signals are values other than +/-45°, i.e. -30° for the I signal and +60° for the Q signal. Nevertheless, the inventor found that using the arrangement of Figure 6b. gave the best mode of operation for reasons which will be explained in the following text.

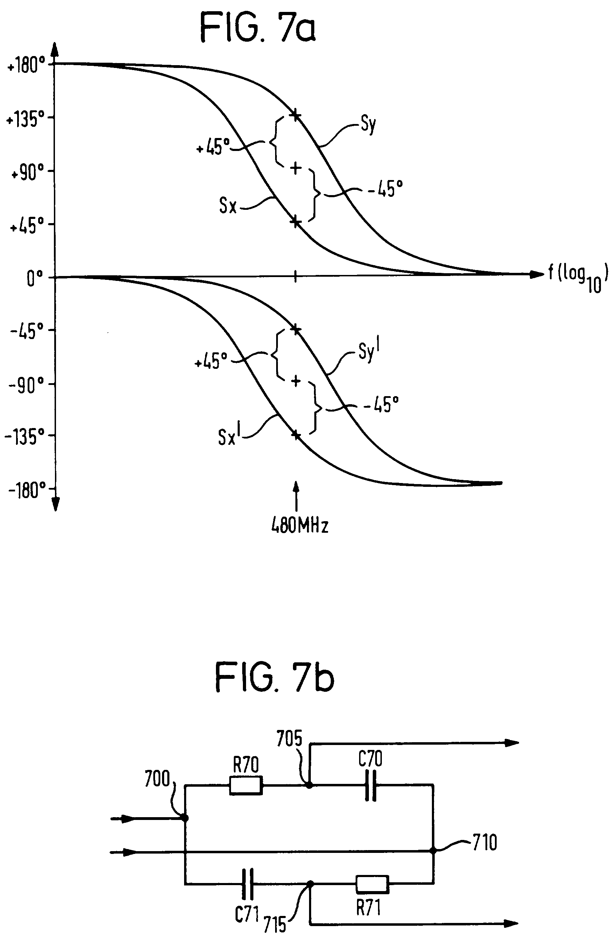

Figures 7a and 7b respectively illustrate the a.c. analysis of the two all pass filters of Figure 6b and a circuit diagram of the all pass filters of Figure 6b.

Referring to Figure 7a, this illustrates the a.c. analysis of the differential output signals of the two all pass filters 22b, 22c that have respectively been designed to introduce a -45° phase shift and a +45° phase shift to the two differential input signals, respectively S8, S8' and S9, S9'. If, for the purposes of the following explanation, the respective differential input signals into filters 22b and 22c are designated Ss, Ss' and St, St' and the respective, phase shifted, differential output signals are designated Sx, Sx' and Sy, Sy' this will help to ease explanation and promote understanding. Furthermore, assume for the present that the differential input signals Ss, Ss' and St, St' are in phase, i.e. there is no phase difference between them.

The values of the components of the two all pass filters 22b, 22c can be selected such that the respective filters 22b, 22c provide phase shifts of -45° and +45° to the respective input signals Ss, Ss' and St, St' at the required second IF, i.e. 480MHz. It can be seen that from Figure 7a that there exists a 90° phase difference between the signals Sx and Sy and similarly between signals Sx' and Sy'.

It therefore follows that if the differential input signals to the filters 22b and 22c are I and Q signals, i.e. that the differential input signals have 90° phase differences, the respective differential output signals will have 180° phase differences: obviously, the I filter would have to introduce a 45° phase lag while the Q filter would have to introduce a 45° phase lead, otherwise the I and Q input signals would have no phase difference at the outputs of the filters.

It would be possible to produce one all pass filter that would provide the appropriate 90° phase difference to just one of the differential input signals - see Figure 6a. However, in practice, it would be difficult to ensure the accuracy of the required 90° phase shift due to variations in the component values.

As stated earlier, it is also possible to design two all pass filters that introduce a total phase difference of 90° between two differential input signals, yet their values of phase lead and phase lag are different, i.e. one filter introduces a 60° phase lead and the other introduces a 30° phase lag. However, if there is a cause for variation between the respective components that constitute the all pass filters, then the resultant phase shift between the differential output signals will tend to deviate from 90°, this will ultimately result in the image frequency not being sufficiently rejected or attenuated.

The inventor discovered that if the all pass filters 22b, 22c were designed to respectively introduce a -45° phase shift and a +45° phase shift to the I and Q differential input signals, the filters 22b, 22c were much more tolerant with respect to variations in component values, especially in the case where the filters 22b, 22c are integrated on a monolithic semiconductor substrate.

Referring to Figure 7b, this illustrates the circuit diagram of an all pass filter that is composed of two resistors R70, R71 and two capacitors C70, C71. One side of resistor R70, designated by node 700, is connected to one side of capacitor C71. The other side of resistor R70, designated by node 705, is connected to one side of capacitor C70. One side of resistor R71, designated by node 710, is connected to the other side of capacitor C71. The other side of resistor R71, designated by node 715, is connected to the other side of capacitor C70. Therefore, the components R70, C70, R71 and C71 are respectively connected in series to form an unbroken ring.

The differential input signals, i.e. S8 and S8', are applied to nodes 700 and 710 and the respective, phase shifted differential output signals, i.e. S10 and S10', are present on nodes 705 and 715.

The component values required to create an all pass filter that produces a 45° phase lag at 480MHz are R70=R71=4000hms and C70=C71=1.8pFarads and the component values required to create an all pass filter that produces a 45° phase lead at 480MHz are R70=R71=2000hms and C70=C71=0.6pFarads. It should be noted that for all pass filters that provide 45° phase leads and lags, the respective values of the resistive and capacitive components used in the phase lag filter are multiples of the respective values of the resistive and capacitive components used in the phase lead filter: it is for this reason that all pass filters that are integrated on a monolithic semiconductor substrate are less susceptible to component variations than a hybrid solution and thus provide a phase difference between the differential output signals which is as close to 90° as possible.

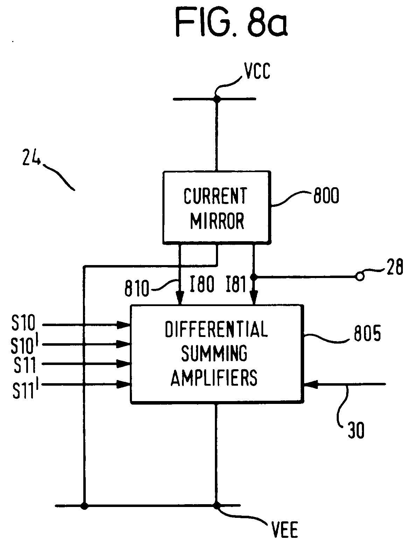

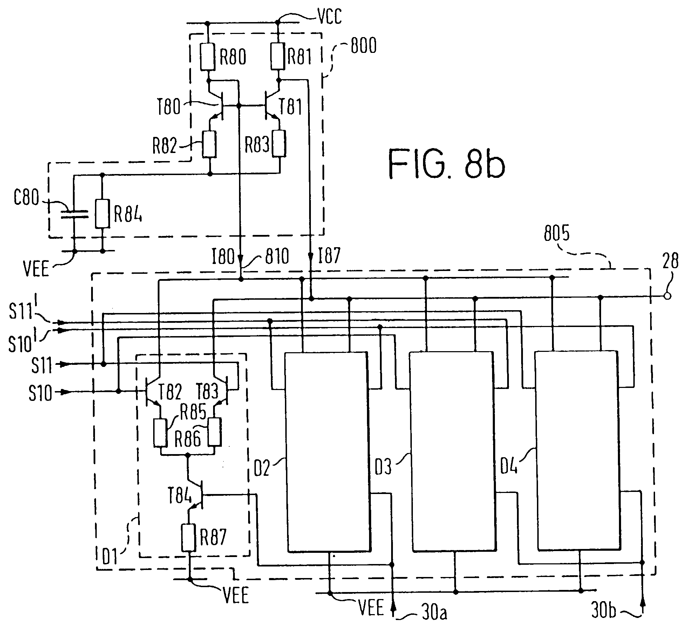

Figures 8a and 8b respectively illustrate detailed block and circuit diagrams of the summer of Figure 1a.

Referring to Figure 8a, the summer 24 can be separated into two functional circuits. The first of these functional circuits being the current mirror 800 and the second being the differential summing amplifier 805, the former acting as an active load for the latter. The current mirror is connected between the positive and negative voltage sources VCC, VEE and provides two current signals I80, I81 on the respective terminals 810 and 28, the latter terminal supplying the required single ended output current signal. The summing amplifier 805 is connected to the positive source VCC, via the current mirror 800, and the negative source VEE. It receives the respective signals S10, S10' , S11, S11' from the respective filters 22b and 22c and is controlled via an input 30.

Referring to Figure 8b, it can be seen that the current mirror 800 comprises five resistors R80-R84, one capacitor C80 and two npn-type transistors T80, T81 and that there are four differential amplifiers D1-D4 that constitute the differential summing amplifier 805, each of which is implemented using identical components. Each differential amplifier comprises three resistors R85-R87 and three npn-type transistors T82-T84.

Referring to the current mirror 800, resistors R80 and R81 are respectively connected between the supply VCC and the respective collectors of transistors T80 and T81. The collector of transistor T80 is connected to the base terminals of transistors T80 and T81 and is designated 810. The respective emitters of transistors T80 and T81 are connected to one side of the respective resistors R82 and R83 whose other sides are connected to the source VEE via resistor R84: capacitor C80 being connected in parallel with R84.

Referring to the differential amplifiers D1-D4, the collector of transistor T82 is connected to the base terminals 810 of transistors T80 and T81 and'the collector of transistor T83 is connected to the collector 28 of transistor T81 i.e. the output of the tuning stage 10. The respective emitters of transistors T82 and T83 are connected to one side of the respective resistors R85 and R86 whose other sides are connected to the collector of transistor T84. The emitter of transistor T84 is connected to the source VEE via resistor R87.

Transistor T84 acts as a switch; that is controlled via its base terminal, and it determines whether or not the differential amplifier is functional or not. The functionality of differential amplifiers D1 and D2 is controlled via terminal 30a and the functionality of differential amplifiers D3 and D4 is controlled via terminal 30b. The functionality of the differential amplifiers D1 and D2 is mutually exclusive with respect to the functionality of the differential amplifiers D3 and D4 i.e. when D1 and D2 are functional, D3 and D4 are non-functional and vice-versa.

The respective base terminals of transistors T82 and T83 of the respective differential amplifiers D1-D4 receive the following signals:

| | |
|---|---|
| T82_{D1}: S10 | T83_{D1}: S11 |
| T82_{D2}: S11' | T83_{D2}: S10' |
| T82_{D3}: S10 | T83_{D3}: S11' |
| T82_{D4}: S11 | T83_{D4}: S10' |

Therefore, when the differential amplifiers D1 and D2 are functional, only the 480MHz signal associated with channel 1 is present at the output 28 of the tuning stage 10, the 480MHz signal associated with channel 33 being substantially rejected. Similarly, when the differential amplifiers D3 and D4 are functional, the 480MHz signal associated with channel 33 is present at the output 28 of the tuning stage 10, the 480MHz signal associated with channel 1 being substantially rejected.

In order to provide good image rejection, it is essential that the low power amplifiers 14, 16 are well matched and that the all pass filters are well matched 22b, 22c. Good matching of the low power amplifiers 14, 16 and filters 22b, 22c can only effectively be achieved by integrating them on a common semiconductor substrate. Furthermore, it is also possible to integrate the low noise amplifier 12, the mixer 18 and the summer 24 onto the same substrate as the amplifiers 14, 16 and filters 22b, 22c so that a well matched, compact, cost effective satellite tuning stage can be realised.

Although this invention has been described in connection with certain preferred embodiments, it should be understood that the present disclosure is to be considered as an exemplification of the principles of the invention and that there is no intention of limiting the invention to the disclosed embodiments. On the contrary, it is intended that all alternatives, modifications and equivalent arrangements as may be included within the spirit and scope of the appended claims be covered as part of this invention.

## Claims

1. A tuner stage (10) of a satellite receiver system, receiving a first signal (S1) from a low noise block, for selecting a required channel carrier frequency, characterised in that it comprises:
an oscillator (20) for providing second and third signals (S4, S5) at a selected frequency (f_{LO}), said second and third signals having a phase difference of substantially 90°;
a first mixer (18a) for mixing said first signal (S1) with said second signal (S4) and providing a fourth signal (S6);
a second mixer (18b) for mixing said first signal (S1) with said third signal (S5) and providing a fifth signal (S7);
a means (22), that produces sixth and seventh signals (S10, S11), for introducing a further phase shift of substantially 90° between said fourth and fifth signals (S6, S7) at a required frequency that is equal to the difference between said selected frequency (f_{LO}) and said required channel carrier frequency;
a first summer for summing said sixth and seventh signals (S10, S11); and
a first filter, whose centre frequency equals said required frequency, for filtering the summed signals.

2. A tuner stage according to claim 1, characterised in that it further comprises:
a second summer for summing said sixth signal and the inverse signal of said seventh signal; and
a means for controlling said first and second summers such that only one of said summers provides summed signals.

3. A tuner stage according to claims 1 or 2, characterised in that it further comprises:
a first amplifier (12) for amplifying said first signals (S1);
a second amplifier (14) for amplifying said fourth signal (S6); and
a third amplifier (16) for amplifying said fifth signal (S7).

4. A tuner stage according to claim 3, characterised in that it further comprises:
a first low pass filter placed between said first mixer (18a) and said second amplifier (14); and
a second low pass filter placed between said second mixer (18b) and said third amplifier (16).

5. A tuner stage according to any of the above claims, characterised in that:
the means (22) for introducing a further phase shift between said fifth and sixth signals (S6, S7) comprises a means (22b) for introducing a phase-lag of substantially 45° into one of said fifth or sixth signals and a means (22c) for introducing a phase-lead of substantially 45° into the other of said fifth or sixth signals.

6. A tuner stage according to any of the above claims, characterised in that all of the signals, with the exception of said summed signals, are differential signals.

7. A tuner stage according to any of the above claims, characterised in that:
said first amplifier (12) is a transconductance amplifier; and
said second and third amplifiers (14, 16) are transimpedance amplifiers.

8. A tuner stage according to any of the above claims, characterised in that said oscillator (20) provides limited amplitude output signals (S4, S5) that each have a duty cycle of one.

9. A tuner stage according to any of the claims 5-8, characterised in that said means (22b) for introducing a phase-lag of substantially 45° and said means for introducing a phase-lead of substantially 45° are Hilbert filters.

10. A tuner stage according to any of the above claims, characterised in that said first filter is a surface acoustic wave filter.

11. A tuner stage according to any of the above claims, characterised in that it is implemented on a single semiconductor substrate, with the exception of said oscillator (20) and said first filter.

12. A tuner stage according to any of the above claims, characterised in that it is incorporated within a television set and/or a video recorder.

13. A method for selecting a required channel carrier frequency from a block of input signals of a satellite receiver system, characterised in that it comprises the following steps:
applying said block of input signals to a first and a second mixer;
applying a signal, that has a selected frequency (f_{LO}) and that is in-phase with respect to a desired carrier frequency of said block signals, to said first mixer;
applying a signal, that has said selected frequency (f_{LO}) and that has a phase difference of substantially 90° with respect to said desired carrier frequency, to said second mixer;
introducing a further phase difference of substantially 90° between the output signals of said mixers, at a required frequency that is equal to the difference between said selected frequency (f_{LO}) and said required channel carrier frequency, to provide first and second signals;
summing, with a first summer, said first and second signals; and
filtering the summed signals with a filter whose centre frequency equals said required frequency.

14. A method according to claim 13, characterised in that it further comprises the following steps:
summing, with a second summer, said first signal and the inverse of said second signal; and
controlling said first and second summers such that only one summer provides summed signals.

15. A method according to claims 13 or 14, characterised in that the step of introducing a further phase difference of substantially 90° between the output signals of said mixers comprises the following steps:
introducing a phase-lag of substantially 45° into one of said output signals of one of said mixers; and
introducing a phase-lead of substantially 45° into the other of said output signals of the other of said mixers.

16. A method according to any of the claims 13-15, characterised in that it further comprises the following steps:
amplifying said block signals prior to their application to said first and second mixers;
filtering out high frequency signals of said output signals of said mixers;
amplifying the low frequency signals prior to introducing said further phase difference of substantially 90°.

17. A tuner stage (10) for selecting a channel at a required carrier frequency from an incoming signal (S1) comprising a plurality of different carrier frequencies, the tuner stage comprising:
a terminal for receiving said incoming signal (S1);
first and second mixer circuits (18a,18b) connected to said terminal for mixing said incoming signal with respective mixer signals (S4,S5) which are at the same selected frequency and which have a phase shift of substantially 90° between them, for generating respective mixer output signals (S6,S7);
a phase shift circuit (22) connected to receive said mixer output signals and arranged to introduce a phase shift of substantially 90° between them at an intermediate frequency that is equal to the difference between said selected frequency and said required carrier frequency, to generate first and second signals (S10,S11);
a summing circuit (24) for summing said first and second signals to generate a combined signal (28); and
a filter (26) with a centre frequency matching said intermediate frequency, for filtering said combined signal to select said channel.

18. A method for selecting a channel at a required frequency from an incoming signal (S1) comprising a plurality of different carrier frequencies, comprising the steps of:
mixing said incoming signal (S1) with first and second mixer signals (S4,S5) which are at the same selected frequency and have a phase shift of substantially 90° between them, to produce first and second mixer output signals (S6,S7);
introducing a phase shift of substantially 90° between the first and second mixer output signals at an intermediate frequency that is equal to the difference between said selected frequency and said required carrier frequency to generate first and second signals (S10,S11);
summing said first and second signals to create a combined signal (28); and
filtering said combined signal (28) by means of a filter (26) with a centre frequency matching said intermediate frequency to select said channel.
